Europäisches Patentamt

European Patent Office

Office européen des brevets

(19)

(11) Veröffentlichungsnummer : **0 402 510 B1**

# (12) EUROPÄISCHE PATENTSCHRIFT

(45) Veröffentlichungstag der Patentschrift :
**13.09.95 Patentblatt 95/37**

(51) Int. Cl.⁶ : **H03H 21/00**

(21) Anmeldenummer : **89110896.1**

(22) Anmeldetag : **15.06.89**

(54) **Verfahren und Netzwerkanordung zur Erzielung einer stetigen Änderung der Übertragungsfunktion eines adaptiven rekursiven Netzwerks zur Verarbeitung zeitdiskreter Signale.**

(43) Veröffentlichungstag der Anmeldung :
**19.12.90 Patentblatt 90/51**

(45) Bekanntmachung des Hinweises auf die
Patenterteilung :
**13.09.95 Patentblatt 95/37**

(84) Benannte Vertragsstaaten :
**DE FR GB IT NL**

(56) Entgegenhaltungen :
**IEEE TRANSACTIONS ON CIRCUITS AND SY-STEMS, Band CAS-32, Nr. 1, Januar 1985, Seiten 68-88, New York, US; L. GAZSI: "Explicit formulas for lattice wave digital filters"**

(56) Entgegenhaltungen :
**CIRCUIT THEORY AND DESIGN - PROCEE-DINGS OF THE 1981 EUROPEAN CONFEREN-CE ON CIRCUIT THEORY AND DESIGN, 25.-28. August 1981, Seiten 1052-1057, The Hague, NL; L. GAZSI: "Hardware implementation of wave digital filters using programmable digital signal processors"**

(73) Patentinhaber : **SIEMENS AKTIENGESELLSCHAFT Wittelsbacherplatz 2 D-80333 München (DE)**

(72) Erfinder : **Gazsi, Lajos, Dr.-Ing. Faunastrasse 23 D-4000 Düsseldorf (DE)**
Erfinder : **Brückmann, Dieter, Dr.-Ing. Zur Lindung 9 D-4000 Düsseldorf (DE)**

EP 0 402 510 B1

## Beschreibung

Die Erfindung betrifft ein Verfahren zur Erzielung einer stetigen Änderung der Übertragungsfunktion eines adaptiven rekursiven Netzwerks zur Verarbeitung zeitdiskreter Signale nach dem Oberbegriff des Patentanspruchs 1 und eine Anordnung zur Durchführung des Verfahrens.

Adaptive Netzwerke, wie etwa adaptive Digitalfilter, sind in vielen Bereichen der zeitdiskreten Signalverarbeitung, insbesondere in den Bereichen Systemanalyse, Echokompensation bei Zweidraht-Vierdrahtübergängen, Leitungsentzerrung und Sprachverarbeitung, von großer Bedeutung. Das Charakteristikum solcher adaptiver Netzwerke ist, im Vergleich zu konstanten Netzwerken, daß die Netzwerkparameter, die die Übertragungseigenschaften bestimmen, gegenüber einem Gütefunktional optimal eingestellt werden. Ein derartiges Gütefunktional ist beispielsweise dadurch gegeben, daß der mittlere quadratische Fehler des Ausgangssignals des adaptiven Netzwerks gegenüber einem Referenzsignal minimiert wird. Mit Hilfe verschiedener Verfahren lassen sich die Parameter automatisch auf den gewünschten Wert einstellen. Aus D. A. Pierre, "Optimization Theory with Applications", John Wiley and Sons, New York 1969, ist beispielsweise ein Verfahren bekannt, bei dem die partiellen Ableitungen (Gradient) des Gütefunktionals nach den zu adaptierenden Netzwerkparametern gebildet werden. Für die meisten Gütekriterien ist dieses Verfahren zurückführbar auf die Bildung der partiellen Ableitungen des Ausgangssignals des adaptiven Netzwerks nach den Netzwerkparametern.

Ein derartiges Verfahren wird beispielsweise in der nicht vorveröffentlichten Patentanmeldung EP 89 109 086.2 beschrieben. Dort werden die partiellen Ableitungen des Ausgangssignals des adaptiven Netzwerks nach den einzelnen Parametern mit Hilfe eines Gradientennetzwerks berechnet.

Ein typischen Beispiel für rekursive Netzwerke zur Verarbeitung zeitdiskreter Signale sind Wellendigitalfilter, die sich neben der Realisierung von festen Übertragungsfunktionen auch hervorragend zur Implementierung von adaptiven Systemen eignen. Wellendigitalfilter enthalten Verzögerungen sowie Adaptoren. Die Adaptoren wiederum sind aus Addierern bzw. Substrahierern sowie Multiplizierern, d. h. Verstärkern aufgebaut. Mit Hilfe der Multipliziererkoeffizienten können unterschiedliche Übertragungsfunktionen eingestellt werden. Bei einem adaptiven Wellendigitalfilter stellen die Multipliziererkoeffizienten die Netzwerkparameter dar, die variabel sind und sich automatisch auf die gewünschten Werte einstellen. Gradientennetzwerke können ebenfalls durch Wellendigitalfilter realisiert werden.

Probleme können bei Netzwerken der genannten Art hinsichtlich der Skalierung auftreten, wenn der darstellbare Wertebereich gegeben ist und beispielsweise der Zahlenbereich auf $-1 \leq X \leq 1-2^{-n}$ mit der Wortlänge n beschränkt ist (Festkommaarithmetik). Bei der durch das adaptive System bedingten Veränderung der Parameter muß die Aussteuerbarkeit des Netzwerks zur Realisierung der gewünschten Übertragungsfunktion im definierten Bereich bleiben, so daß keine Sättigungseffekte auftreten können. Zur Verhinderung derartiger unerwünschter Eigenschaften ist es üblich, das Eingangssignal des Netzwerks herunterzu skalieren, was in der Regel eine starke Herabsetzung des Eingangspegels bedeutet. Als Folge ergibt sich ein schlechter Geräuschabstand, der bei einer Quantisierung zu einem Rauschen führt. Insgesamt ergibt sich eine schlechte Dynamik des Netzwerks. Weitere Probleme ergeben sich bei der Erzeugung positiver oder negativer Phasendrehungen.

Es ist deshalb für diese Netzwerke wünschenswert, für unterschiedliche Wertebereiche der Netzwerkparameter unterschiedliche Netzwerkstrukturen vorzusehen. Aus der Veröffentlichung L. Gazsi, "Explicit Formulas for Wave Digital Filters", IEEE Transactions on Circuits and Systems, Vol. CAS-32, No. 1, pp. 68 - 88, Jan. 1985 sind am Beispiel Wellendigitalfilter für verschiedene Wertebereiche des Multipliziererkoeffizienten $\gamma$ eines Zweitoradaptors unterschiedliche Adaptorstrukturen bekannt, die im jeweiligen Wertebereich des Koeffizienten eine optimale Skalierung erlauben.

Beim Übergang von der einem Wertebereich eines Parameters zugeordneten Struktur auf eine andere einem anderen Wertebereich des Parameters zugeordnete Struktur, z.B. wenn die Werte des Parameters sich stetig ändern, können an den Netzwerkausgängen plötzliche Wertänderungen auftreten. Dies wird an FIG 9 der genannten Veröffentlichung L. Gazsi klar. In der Struktur für die Koeffizientenwerte $\gamma > 0$ entspricht, sobald $\gamma = 0$ gewählt wird, der Ausgang der linken Adaptorseite dem Eingang der rechten Seite und der Ausgang der rechten Adaptorseite dem Eingang der linken Seite. In der Struktur für den Filterkoeffizienten $\gamma < 0$ entspricht, sobald $\gamma = 0$ gewählt wird, der Ausgang der linken Adaptorseite dem invertierten Eingang der rechten Seite und der Ausgang der rechten Seite dem invertierten Eingang der linken Adaptorseite. Derartige Wertänderungen können einerseits zu einem abrupten Sprung des Differenz- oder Fehlersignals und andererseits zu Instabilitäten des gesamten adaptiven Systems führen.

Bei Netzwerken der eingangs genannten Art, die unterschiedliche Strukturen für verschiedene Wertebereiche der Parameter bzw. Zustandsvariablen verwenden, muß deshalb gewährleistet sein, daß sich bei stetiger Änderung der Parameter bzw. Zustandsvariablen die Übertragungsfunktion des Netzwerks bzw. das Aus-

2

EP 0 402 510 B1

gangssignal des Netzwerks ebenfalls stetig ändert.

Der Erfindung liegt die Aufgabe zugrunde, ein Verfahren zur Erzielung einer stetigen Änderung der Übertragungsfunktion eines Netzwerks der eingangs genannten Art sowie eine als lineares Digitalfilter ausgeführte Netzwerkanordnung zur Durchführung des Verfahrens anzugeben.

Diese Aufgabe wird bei einem gattungsgemäßen Verfahren durch die kennzeichnenden Merkmale des Patentanspruchs 1 gelöst. Weiter wird die Aufgabe mit einer Anordnung gemäß den kennzeichnenden Merkmalen des Patentanspruchs 3 gelöst.

Die Erfindung hat den Vorteil, daß es mit geringem Aufwand möglich ist, adaptive rekursive Netzwerke zur Verarbeitung zeitdiskreter Signale zu bilden, die eine optimale Skalierung bzw. positive oder negative Phasendrehungen erlauben. Bei stetigen Änderungen der Parameter des Netzwerks ändert sich die Übertragungsfunktion des Netzwerks ebenfalls stetig. Auf diese Weise werden abrupte Sprünge des Fehlersignals oder Instabilitäten des adaptiven Systems vermieden oder doch weitgehend reduziert.

Ausgestalten des Erfindungsgedankens sind in Unteransprüchen gekennzeichnet.

Die Erfindung wird nachfolgend anhand von in den Figuren der Zeichnung dargestellten Ausführungsbeispielen näher erläutert. Dabei sind gleiche Elemente mit gleichen Bezugszeichen versehen. Es zeigt:

FIG 1 die Realisierung eines Mehrtorteilnetzwerks eines linearen Digitalfilters in einem gegebenen Skalierungsbereich,

FIG 2 eine schematische Ausführungsform einer erfindungsgemäßen Netzwerkanordnung,

FIG 3 die schematischen Schritte des erfindungsgemäßen Verfahrens für ein Mehrtorteilnetzwerk nach FIG 1 und

FIG 4 die schematischen Schritte des erfindungsgemäßen Verfahrens für ein Mehrtorteilnetzwerk gemäß FIG 1 mit zusätzlichem schaltbaren Inverter.

Grundgedanke der Erfindung ist es, bei einem adaptiven rekursiven Netzwerk zur Verarbeitung zeitdiskreter Signale die den Zustandsvariablen bzw. Parametern $\gamma_i$ zugeordneten Mehrtorteilnetzwerke zunächst in elementare Teilnetzwerke aufzuspalten, die bezüglich der Parameter $\gamma_i$ entkoppelt sind, d.h. jeweils nur noch von einem Parameter abhängen. Anschließend werden diejenigen elementaren Teilnetzwerke, die z.B. aus Skalierungsgründen unterschiedliche Strukturen für unterschiedliche Parameterbereiche erfordern, durch elementare Teilbereichsnetzwerke mit unterschiedlicher Struktur dargestellt. Zugrunde liegt die Erkenntnis, daß sich bei stetigen Änderungen der Parameter des Netzwerks eine stetige Änderung der Übertragungsfunktion des Netzwerks ergibt, wenn sich als hinreichende Bedingung die Ausgangssignale bzw: die Übertragungsfunktion des elementaren Teilnetzwerks, in den der jeweilige Parameter eingebettet ist, nur stetig ändern.

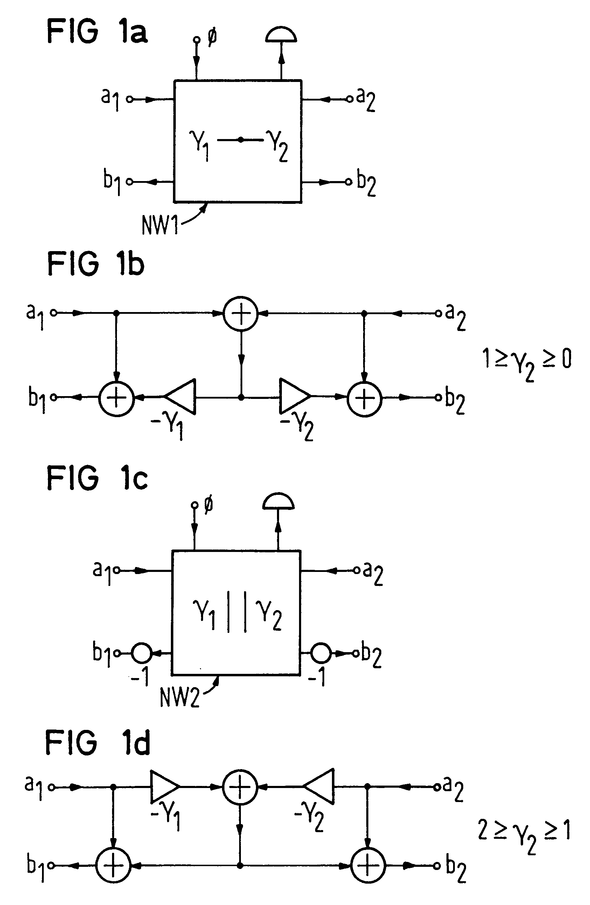

Ein erstes Ausführungsbeispiel für das erfindungsgemäße Verfahren geht von einem Mehrtorteilnetzwerk, nämlich einem Dreitorserienadaptor für ein adaptives Wellendigitalfilter, der an einem Tor mit einem Widerstand abgeschlossen ist, aus. FIG 1a gibt ein symbolisches Schaltbild für den Dreitorserienadaptor an, der aus dem Teilnetzwerk NW1 mit den Parametern $\gamma_1$ und $\gamma_2$ besteht. Das erste Tor wird durch den ersten Eingang $a_1$ und den ersten Ausgang $b_1$, das zweite Tor durch den zweiten Eingang $a_2$ und den zweiten Ausgang $b_2$ und das dritte Tor durch den dritten Eingang $\phi$ und den dritten Ausgang mit Widerstand gebildet. Eine direkte Realisierung des Dreitorserienadaptors zeigt FIG 1b, beider der Adaptor Addierer und als Multiplizierer invertierende Verstärker mit den Verstärkungsfaktoren $-\gamma_1$ bzw. $-\gamma_2$ aufweist. Es läßt sich nachweisen, daß bei gegebenem Eingangssignal das am zweiten Ausgang $b_2$ anliegende Ausgangssignal des Adaptors richtig skaliert ist, wenn der Parameter $\gamma_2$ im Wertebereich $0 \leqq \gamma_2 \leqq 1$ liegt.

Aus Skalierungsgründen muß für Werte $\geqq 1$ und $\leqq 2$ des Parameters $\gamma_2$ entsprechend FIG 1c bzw. FIG 1d ein Dreitorparalleladaptor gewählt werden. Im Prinzipbild der FIG 1c enthält der Dreitorparalleladaptor das Netzwerk NW2 und je einen den beiden Ausgängen vorgeschalteten Inverter. Die Realisierung des im Wertebereich $1 \leqq \gamma_2 \leqq 2$ richtig skalierten Teilnetzwerks ist aus FIG 1d zu erkennen. Die Umschaltung zwischen beiden Strukturen muß beim Parameterwert $\gamma_2 = 1$ erfolgen. Anhand von FIG 1b ergeben sich für die beiden Ausgänge folgende Gleichungen:

$$b_1 = a_1 \cdot (1 - \gamma_1) - \gamma_1 \cdot a_2 \quad (1a)$$
$$b_2 = -a_1. \quad (1b)$$

Entsprechend erhält man aus FIG 1d die Gleichungen

$$b_1 = a_1 \cdot (1 - \gamma_1) - a_2 \quad (2a)$$
$$b_2 = -\gamma_1 \cdot a_1. \quad (2b)$$

Bei direkter Realisierung des Dreitorserienadaptors kann also bei stetiger Änderung der Parameter des Teilnetzwerks eine stetige Änderung der Übertragungsfunktion nicht gewährleistet werden. Gleiches gilt wie bereits gesagt, für die in bestimmten Wertebereichen der Parameter gut skalierten Strukturen von Zweitoradaptoren.

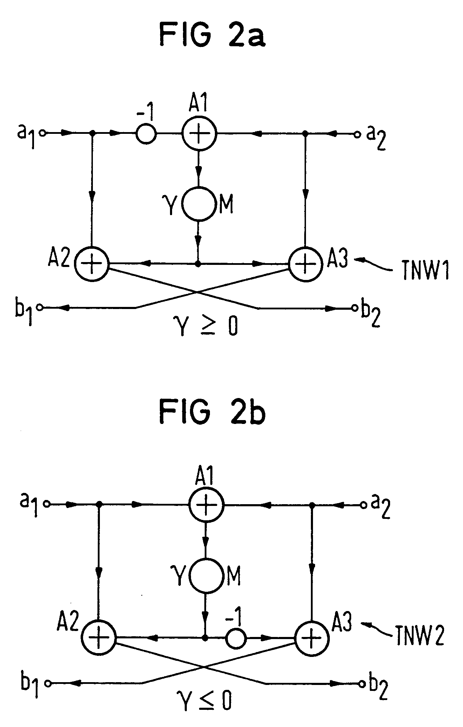

Gemäß FIG 2 baut das erfindungsgemäße Verfahren auf elementaren Teilbereichsnetzwerken mit unterschiedlicher Struktur auf, deren (resultierende) Übertragungsfunktion sich bei stetigen Änderungen des Pa-

3

rameters ebenfalls stetig ändert. Derartige elementare Teilbereichsnetzwerke unterschiedlicher Struktur sind beim Ausführungsbeispiel eines adaptiven Wellendigitalfilters ein Zweitoradaptor gemäß FIG 2. Der gemäß FIG 2a erste und gemäß FIG 2b zweite Zweitoradaptor haben anhand der schematischen Schaltbilder die Gemeinsamkeiten, daß der erste Eingang $a_1$ mit einem ersten Addierer A1 und einem zweiten Addierer A2, der zweite Eingang $a_2$ mit dem ersten Addierer A1 und einem dritten Addierer A3, der erste Addierer A1 ausgangsseitig über einen Multiplizierer M mit dem zweiten Addierer A2 und dem dritten Addierer A3, der zweite Addierer A2 ausgangsseitig mit dem zweiten Ausgang $b_2$ und der dritte Addierer A3 ausgangsseitig mit dem ersten Ausgang $b_1$ verbunden sind. Beim ersten Zweitoradaptor TNW1 besitzt der erste Addierer A1 bezüglich des ersten Eingangs $a_1$ einen invertierten Eingang und beim zweiten Zweitoradaptor TNW2 besitzt der dritte Addierer A3 bezüglich des Multiplizierers M einen invertierten Eingang.

Es ist bekannt, daß die Zweitoradaptor-Struktur gemäß FIG 2a für Parameterwerte $\gamma \geqq 0$ gut skaliert ist. Andererseits erlaubt die Zweitoradaptor-Struktur gemäß FIG 2b für Parameterwerte $\gamma \leqq 0$ eine gute Skalierung. Die Systemgleichungen für die Struktur nach FIG 2a lauten:

$$b_1 = \gamma \cdot (a_2 - a_1) + a_2, \gamma \geqq 0 \quad (3a)$$
$$b_2 = \gamma \cdot (a_2 - a_1) + a_1, \gamma \geqq 0. \quad (3b)$$

Für die Struktur nach FIG 2b lauten die Gleichungen:

$$b_1 = \gamma \cdot (a_1 + a_2) + a_2, \gamma \leqq 0 \quad (4a)$$
$$b_2 = \gamma \cdot (a_1 + a_2) + a_1, \gamma \leqq 0 \quad (4b).$$

Die Umschaltung zwischen beiden Strukturen muß bei $\gamma = 0$ erfolgen und es ist offensichtlich, daß für beide Strukturen gilt, daß für $\gamma = 0$ der erste Ausgang $b_1$ dem zweiten Eingang $a_2$ und der zweite Ausgang $b_2$ dem ersten Eingang $a_1$ entspricht. Das bedeutet, daß sich bei einer stetigen Änderung des Parameters $\gamma$ die Übertragungsfunktion des aus den beiden elementaren Teilbereichsnetzwerken gemäß FIG 2 gebildeten elementaren Teilnetzwerks ebenfalls stetig ändert.

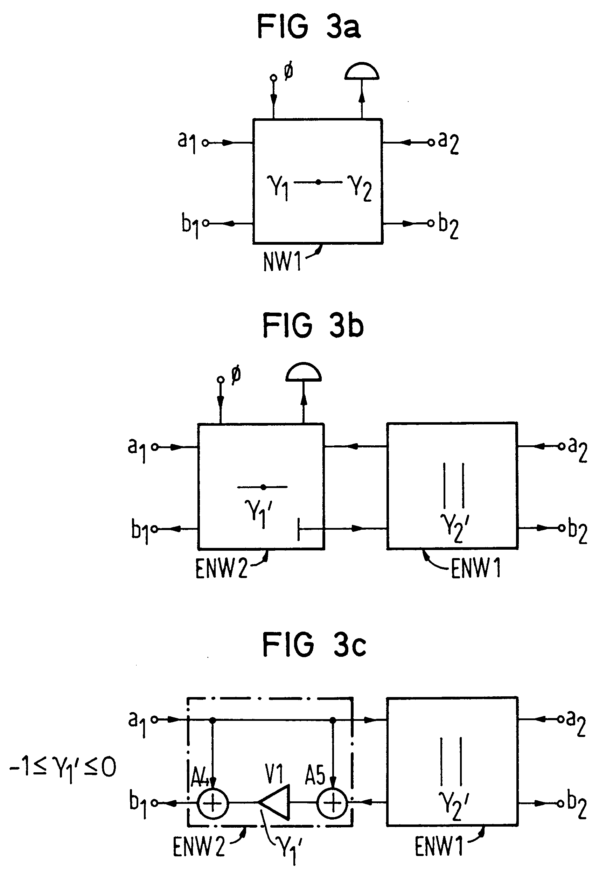

Ausgehend von den elementaren Teilbereichsnetzwerken gemäß FIG 2, in die elementare Teilnetzwerke aufgeteilt werden, deren Parameter Werte in einem gegebenen Gesamtwertebereich annehmen können, wird das erfindungsgemäße Verfahren anhand der FIG 3 erläutert. Der bereits in FIG 1 beschriebene Dreitorserienadaptor, der am Ausgang des dritten Tors mit einem Widerstand abgeschlossen ist und dessen direkte Realisierung die der Erfindung zugrundeliegende Aufgabe nicht zu lösen vermag, wird in einem ersten Verfahrensschritt durch elementare Teilnetzwerke dargestellt, die bezüglich der Parameter $\gamma_l$ entkoppelt sind.

Beispielsweise für Wellendigitalfilter sind derartige elementare Teilnetzwerke in der Veröffentlichung A. Fettweis und K. Meerkötter, "On Adaptors for Wave Digital Filters", IEEE Transactions on Acoustic Speech Signal Processing, Vol. ASSP-23, pp. 516 - 525, Dezember 1975 beschrieben. Anhand der genannten Veröffentlichung läßt sich nachweisen, daß der Dreitorserienadaptor mit den Parametern $\gamma_1$ und $\gamma_2$, der an einem Tor mit einem Widerstand abgeschlossen ist, in einen einfachen Zweitoradaptor und einen an einem Tor reflexionsfrei abgeschlossenen Dreitorserienadaptor aufgespalten werden kann. Ausgehend von der Struktur gemäß FIG 3a erhält man somit das schematische Bild gemäß FIG 3b. Der einfache Zweitoradaptor ENW1 hängt dabei nur noch vom Parameter $\gamma_2'$ ab und läßt sich entsprechend der erfindungsgemäßen Anordnung nach FIG 2 realisieren. Der reflexionsfrei abgeschlossene Dreitorserienadaptor ENW2 hängt vom Parameter $\gamma_1'$ ab, der immer positiv ist, so daß für die Realisierung nur eine Struktur erforderlich ist, da der Parameter $\gamma_1'$ nur Werte in einem Bereich des gegebenen gesamten Wertebereichs, nämlich $\gamma_1' \geqq 0$ annehmen kann.

FIG 3c zeigt ein schematisches Bild einer Realisierung des reflexionsfrei abgeschlossenen Dreitorserienadaptors ENW2. Diese besteht aus den beiden Addierern A4 und A5 sowie dem invertierenden Verstärker V1 mit dem Verstärkungsfaktor $\gamma_1'$. Der erste Eingang führt auf die beiden Addierer A4 und A5 sowie auf den ersten Eingang des Zweitoradaptors ENW1. Der zweite Eingang entspricht dem ersten Ausgang des Zweitoradaptors ENW1 und führt auf den Addierer A5, dessen Ausgang über den Verstärker V1 auf den Addierer A4 geht. Der Ausgang des Addierers A4 entspricht dem ersten Ausgang $b_1$ des Netzwerks ENW2.

In vielen der Erfindung zugrundeliegenden adaptiven Netzwerken, speziell in adaptiven Wellendigitalfiltern, ist es notwendig, Vorzeichenumkehrer bzw. Inverter zu realisieren, die ein- oder ausgeschaltet werden können. Diese schaltbaren Inverter werden z.B. zur Realisierung von positiven oder negativen Phasendrehungen benutzt. Es ist unmittelbar einsichtig, daß eine direkte Implementierung eines schaltbaren Inverters keinen stetigen Übergang des Filterausgangssignals bzw. der Filterübertragungsfunktion erlaubt, so daß es zu sprunghaften Signalstörungen kommt.

Ein derartiger, unter Umständen aus Skalierungsgründen erforderlicher schaltbarer Inverter verursacht bei einer Signalumschaltung in der Regel einen Signalsprung. Ein derartiger Sprung ist jedoch insbesondere bei adaptiven Systemen, die nach dem Gradientenverfahren arbeiten, unerwünscht, da dann der Gradient nicht gebildet werden kann. Beim erfindungsgemäßen Verfahren ist vorgesehen, einen ggf. vorhandenen schaltbaren Inverter mit einem elementaren Teilnetzwerk, dessen Parameter nur Werte in einem Bereich des gegebenen gesamten Wertebereichs annehmen kann, zu einem kombinierten Teilnetzwerk zusammenzufassen.

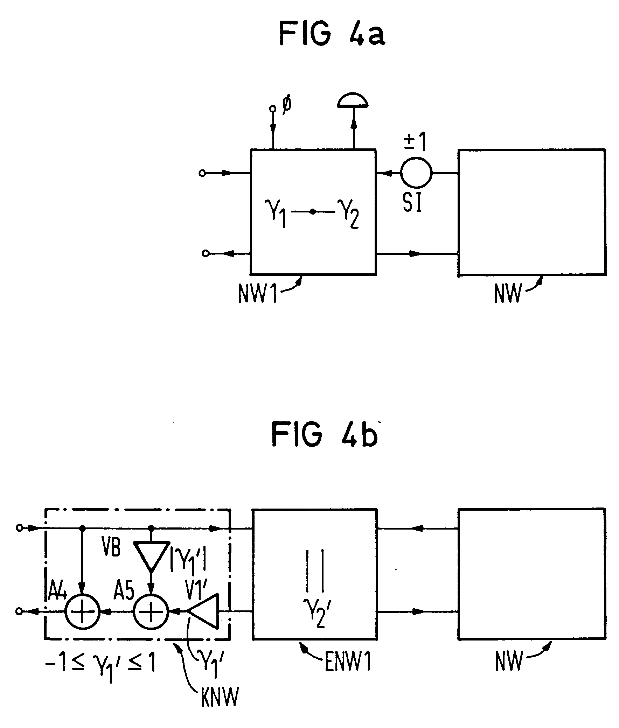

An einem gemäß FIG 4 als Ausführungsbeispiel dargestellten Wellendigitalfilter soll dies erläutert werden.

FIG 4a zeigt am Beispiel des bereits in FIG 1 eingeführten Dreitorserienadaptors NW1, der an einem Tor mit einem Widerstand abgeschlossen ist, und einem am zweiten Eingang liegenden schaltbaren Inverter SI den erfindungsgemäßen Verfahrensschritt. Der schaltbare Inverter SI liegt ausgangsseitig an einem Netzwerk NW, das wiederum eingangsseitig mit dem zweiten Ausgang des Dreitorserienadaptors NW1 verbunden ist. Die Struktur des Netzwerks NW kann für das erfindungsgemäße Verfahren unberücksichtigt bleiben.

Entsprechend den anhand von FIG 3 erläuterten erfindungsgemäßen Verfahrensschritten wird der Dreitorserienadaptor NW1 zunächst in den Zweitoradaptor ENW1 und den reflexionsfrei abgeschlossenen Dreitorserienadaptor ENW2 aufgespalten. Anschließend wird der schaltbare Inverter mit dem reflexionsfrei abgeschlossenen Dreitorserienadaptor ENW2 durch eine dem Fachmann geläufige Netzwerksumformung zu einem kombinierten Teilnetzwerk KNW zusammengefaßt. Dazu wird zunächst der dem Addierer A5 in FIG 3c ausgangsseitig nachgeschaltete Verstärker V1 an die Eingänge des Addierers gelegt. Anschließend wird der schaltbare Inverter SI durch den Zweitoradaptor ENW1 "durchgeschoben" und mit dem reflexionsfrei abgeschlossenen Dreitorserienadaptor ENW2 kombiniert. Es ergibt sich, daß der dem Addierer bezüglich des zweiten Eingangs vorgeschaltete Verstärker V1' mit dem Verstärkungsfaktor $\gamma_1'$ weiterhin als Inverter ausgebildet ist, während der dem Addierer A5 bezüglich des ersten Eingangs $a_1$ vorgeschaltete Verstärker VB als Betragsbildner mit der Verstärkung des Betrags von $\gamma_1'$ ausgebildet ist. Während bei dem elementaren Teilnetzwerk ENW2 gemäß FIG 3c der Parameter $\gamma_1'$ nur Werte in einem Bereich des gegebenen gesamten Wertebereichs, nämlich Werte $\geq$ -1 und $\leq$ 0 annehmen konnte, kann der Parameter $\gamma_1'$ für das kombinierte Teilnetzwerk KNW nunmehr Werte im gegebenen Gesamtwertebereich, d.h, im Bereich - 1 $\leq \gamma_1' \leq$ 1 annehmen. Auf diese Weise ist gleichzeitig der Vorzeichenumkehrer realisiert. Es ist offensichtlich, daß bei stetigen Änderungen des Parameters $\gamma_1'$ eine stetige Änderung des Filterausgangssignals bzw. der Übertragungsfunktion erfolgt.

## Patentansprüche

1.  Verfahren zur Erzielung einer stetigen Änderung der Übertragungsfunktion eines adaptiven rekursiven Wellendigitalfilters zur Verarbeitung zeitdiskreter Signale bei stetigen Änderungen der Multiplizierkoeffizienten ($\gamma_I$) des Wellendigitalfilters, bei dem das Wellendigitalfilter den Multiplizierkoeffizienten ($\gamma_I$) zugeordnete Mehrtorteilnetzwerke (NW1) enthält und gegebenenfalls schaltbare Inverter (SI) realisiert, **gekennzeichnet durch**
    folgende Schritte:
    a) die Mehrtorteilnetzwerke (NW1) werden durch elementare Teilnetzwerke (ENW1, ENW2) realisiert, die bezüglich der Multiplizierkoeffizienten ($\gamma_1$) entkoppelt sind;
    b) elementare Teilnetzwerke (ENW1), deren Multiplizierkoeffizienten ($\gamma_2'$) Werte in einem gegebenen Gesamtwertebereich annehmen können, werden jeweils durch elementare Teilbereichsnetzwerke (TNW1, TNW2) mit unterschiedlicher Struktur realisiert, die an einandergrenzenden Wertebereichen der jeweiligen Mulitplizierkoeffizienten ($\gamma_2'$) zugeordnet sind und deren Übertragungsfunktion sich bei stetigen Änderungen des Multiplizierkoeffizienten ($\gamma_2'$) stetig ändert, wobei die Teilbereichsnetzwerke derart ausgebildet sind, daß eine stetige Übertragungsfunktion im Übergang von einem zum anderen Wertebereich gewährleistet ist;
    c) können Werte der Multiplizierkoeffizienten ($\gamma_1'$) nur Werte in einen Bereich des gegebenen gesamten Wertebereichs annehmen, so werden je ein schaltbarer Inverter (SI) und elementare Teilnetzwerke (ENW2) durch ein kombiniertes Teilnetzwerk (KNW) realisiert, dessen Multiplizierkoeffi zienten ($\gamma_1'$) dann Werte im gesamten Wertebereich annehmen kann.

2.  Verfahren nach Anspruch 1,
    **dadurch gekennzeichnet**, daß jeweils positiven bzw. negativen Parameter-Wertebereichen elementare Teilbereichsnetzwerke (TNW1, TNW2) mit unterschiedlicher Struktur zugeordnet werden.

3.  Netzwerkanordnung zur Durchführung des Verfahrens nach Anspruch 1,
    **dadurch gekennzeichnet**, daß die elementaren Teilnetzwerke (ENW1), deren Parameter ($\gamma_2'$) Werte in einem gegebenen Gesamtwertebereich annehmen können, durch erste und zweite Zweitoradaptoren (TNW1, TNW2) dargestellt werden, die jeweils einen ersten ($a_1$) und einen zweiten ($a_2$) Eingang sowie einen ersten ($b_1$) und zweiten ($b_2$) aufweisen, bei denen der erste Eingang ($a_1$) mit einem ersten AI) und zweiten (A2) Addierer, der zweite Eingang ($a_2$) mit dem ersten (A1) und einem dritten (A3) Addierer, der erste Addierer (A1) ausgangsseitig über einen Multiplizierer (M) mit dem zweiten (A2) und dritten (A3) Addierer, der zweite Addierer (A2) ausgangsseitig mit dem zweiten Ausgang ($b_2$) und der dritte Addierer (A3)

ausgangsseitig mit dem ersten Ausgang ($b_1$) verbunden sind und bei denen der erste Zweitoradaptor (TNW1) durch einen invertierten Eingang des ersten Addierers (A1) der mit dem ersten Eingang ($a_1$) verbunden ist und der zweite Zweitoradaptor (TNW2) durch einen invertierten Eingang des dritten Addierers (A3), der mit dem Multiplizierers (M) verbunden ist, gebildet wird, und daß ein elementares Teilnetzwerk (ENW2), dessen Parameter ($\gamma_1'$) nur Werte in einem Bereich des gegebenen Gesamtwertebereiches annehmen kann, durch einen reflexionsfrei abgeschlossenen Dreitoradaptor gebildet wird, welches mit einem schaltbaren Inverter (SI) durch Netzwerkumformung zu einem kombinierten Teilnetzwerk (KNW) zusammengefaßt wird.

**4.** Netzwerkanordnung nach Anspruch 3,
**dadurch gekennzeichnet**, daß der erste Zweitoradaptor (TNW1) positiven und der zweite Zweitoradaptor (TNW2) negativen Multipliziererkoeffizienten oder Verstärkungsfaktoren ($\gamma_i$) zugeordnet ist.

## Claims

1. Method for obtaining a continuous variation in the transfer function of an adaptive recursive wave digital filter for processing time-discrete signals in the case of continuous variations in the multiplier coefficients ($\gamma_i$) of the wave digital filter, in which the wave digital filter includes multi-port subnetworks (NW1) assigned to the multiplier coefficients ($\gamma_i$) and, as the case may be, switchable inerters (SI), charac-terized by the following steps:

   a) the multi-port subnetwork (NW1) are realized by elementary subnetworks (ENW1, ENW2) which are decoupled with respect to the multiplier coefficients ($\gamma_1$);

   b) elementary subnetworks (ENW1), whose multiplier coefficients ($\gamma_2'$) can assume values in a given total value range, are respectively realized by elementary subrange networks (TNW1, TNW2) of differing structure, which are assigned to mutually adjacent value ranges of the respective multiplier coefficients ($\gamma_2'$) and whose transfer function varies continuously upon continuous variations in the multiplier coefficient ($\gamma_2'$), the subrange networks being designed in such a way that a continuous transfer function is guaranteed in the transition from the one to the other value range;

   c) if values of the multiplier coefficients ($\gamma_1'$) can assume only values in a range of the given total value range, a switchable inverter (SI) and elementary subnetworks (ENW2) are realized in each case by a combined subnetwork (KNW) whose multiplier coefficients ($\gamma_1'$) can then assume values in the total value range.

2. Method according to Claim 1, characterized in that elementary subrange networks (TNW1, TNW2) of a different structure are respectively assigned to positive and negative parameter value regions.

3. Network configuration for carrying out the method according to Claim 1, characterized in that the elementary subnetworks (ENW1), whose parameters ($\gamma_2'$) can assume values in a given total value range, are represented by first and second two-port adapters (TNW1, TNw2) which respectively have a first input ($a_1$) and a second input ($a_2$) as well as a first output ($b_1$) and a second output ($b_2$), in the case of which inputs and outputs the first input ($a_1$) is connected to a first adder (A1) and a second adder (A2), the second input ($a_2$) is connected to the first adder (A1) and to a third adder (A3), the first adder (A1) is connected on the output side via a multiplier (M) to the second adder (A2) and third adder (A3), the second adder (A2) is connected on the output side to the second output ($b_2$), and the third adder (A3) is connected on the output side to the first output ($b_1$), and in the case of which inputs and outputs the first two-port adapter (TNW1) is connected via an inverting input of the first adder (A1) to the first input ($a_1$) and the second two-part adapter (TNW2) is formed by an inverting input of the third adder (A3), which is connected to the multiplier (M), and in that an elementary subnetwork (ENW2) whose parameter ($\gamma_1'$) can assume only values in a range of the given total value range is formed by a three-port adapter terminated in a reflection-free fashion, which elementary subnetwork is combined with a switchable inverter (SI) by means of network conversion to form a combined subnetwork (KNW).

4. Network configuration according to Claim 3, characterized in that the first two-port adapter (TNW1) is assigned to positive, and the second two-port adapter (TNW2) is assigned to negative multiplier coefficients or gains ($\gamma_i$).

**Revendications**

1. Procédé pour obtenir une modification continue de la fonction de transfert d'un filtre numérique récursif adaptatif d'ondes pour le traitement de signaux discrets dans le temps dans le cas de modifications continues des coefficients multiplicatifs ($\gamma_i$) du filtre numérique d'ondes, selon lequel le filtre numérique d'ondes contient des réseaux partiels (NW1) à plusieurs portes, qui sont associés aux coefficients multiplicatifs ($\gamma_i$), et forme éventuellement des inverseurs commutables (SI),
caractérisé par les étapes opératoires suivantes :

   a) on forme les réseaux partiels (NW1) à plusieurs portes par des réseaux partiels élémentaires (ENW1,ENW2), qui sont découplés du point de vue des coefficients multiplicatifs ($\gamma_1$);

   b) on forme des réseaux partiels élémentaires (ENW1), dont les coefficients multiplicatifs ($\gamma_2'$) peuvent prendre des valeurs situées dans une gamme globale donnée de valeurs, respectivement par des réseaux élémentaires de gammes partielles (TNW1, TNW2) de structures différentes, qui sont associés à des gammes contiguës de valeurs des coefficients multiplicatifs ($\gamma_2'$) et dont la fonction de transfert varie continûment lorsque l'on fait varier continûment le coefficient multiplicatif ($\gamma_2'$), les réseaux de gammes partielles étant agencés de sorte à garantir une fonction de transfert continue lors du passage d'une gamme de valeurs à une autre;

   c) si des valeurs des coefficients multiplicatifs ($\gamma_1'$) ne peuvent prendre que des valeurs situées dans une gamme de la gamme globale donnée de valeurs, on forme respectivement un inverseur commutable (SI) et des réseaux partiels élémentaires (ENW2) par un réseau partiel combiné (KNW), dont les coefficients multiplicatifs ($\gamma_1'$) peuvent prendre des valeurs situées dans la gamme globale de valeurs.

2. Procédé suivant la revendication 1, caractérisé par le fait que l'on associe des réseaux élémentaires de gammes partielles (TNW1, TNW2) de structures différentes à des gammes respectivement positives ou négatives de valeurs de paramètres.

3. Montage de réseau pour la mise en oeuvre du procédé suivant la revendication 1, caractérisé par le fait que les réseaux partiels élémentaires (ENW1), dont les paramètres ($\gamma_2'$) peuvent prendre des valeurs situées dans une gamme donnée globale de valeurs, sont représentés par des premier et second adaptateurs (TNW1, TNW2) à deux portes, qui ont chacun une première entrée ($a_1$) et une seconde entrée ($a_2$) ainsi qu'une première entrée ($b_1$) et une seconde entrée ($b_2$), et dans lesquels la première entrée ($a_1$) est reliée à des premier et second additionneurs (A1, A2), la seconde entrée ($a_2$) est reliée à des premier et troisième additionneurs (A1, A3), le premier additionneur (A1) est relié, côté sortie, par l'intermédiaire d'un multiplicateur (M) aux second et troisième additionneurs (A2,A3), le second additionneur (A2) est relié, côté sortie, à la seconde sortie ($b_2$) et le troisième additionneur (A3) est relié, côté sortie, à la première sortie ($b_1$), et dans lesquels le premier adaptateur (TNW1) à deux portes est formé d'une entrée inverseuse du premier additionneur (A1), qui est reliée à la première entrée ($a_1$), et le second adaptateur (TNW2) à deux portes est formé d'une entrée inverseuse du troisième additionneur (A3), qui est reliée au multiplicateur (M), et qu'un réseau partiel élémentaire (ENW2), dont le paramètres ($\gamma_1'$) ne peut prendre que des valeurs situées dans une gamme de la gamme globale donnée de valeurs, est formé d'un adaptateur à trois portes, sans réflexion qui est réuni à un inverseur commutable (SI), au moyen d'une conversion de réseau, pour former un réseau partiel combiné (KNW).

4. Montage de réseau suivant la revendication 3, caractérisé par le fait que le premier adaptateur (TNW1) à deux portes est associé à des coefficients multiplicatifs ou facteurs d'amplification ($\gamma_i$) positifs et que le second adaptateur (TNW2) à deux portes est associé à des coefficients multiplicatifs ou facteurs d'amplification ($\gamma_i$) négatifs.

FIG 1a

FIG 1b

$1 \geq \gamma_2 \geq 0$

FIG 1c

FIG 1d

$2 \geq \gamma_2 \geq 1$

# FIG 2a

# FIG 2b

# FIG 3a

# FIG 3b

# FIG 3c

$-1 \leq \gamma_1' \leq 0$

## FIG 4a

## FIG 4b